# EUROPEAN PATENT APPLICATION

(11) **EP 2 876 658 A1**
(43) Date of publication of application: **27.05.2015**
(21) Application number: 14159136.2
(22) Date of filing: 12.03.2014
(51) Int. Cl.: H01H 13/83, H04M 1/22

(54) **Wave guide structure for key module of mobile device and the forming method thereof**

(30) Priority: 20.11.2013 KR 20130141253
(71) Applicant: Dreamtech Co., Ltd, Gyeonggi-do 463-824 (KR)
(72) Inventor: Kim, Young-Ho, 448-505 Gyeonggi-do (KR); Kim, Yong-Hwan, 331-090 Chungcheongnam-do (KR)
(74) Representative: Plougmann & Vingtoft A/S

(57) **Abstract**

A wave guide structure for key module of mobile device and the forming method thereof is provided.

A wave guide structure for key module (100) of mobile device comprises, a substrate (10) equipped with a menu key and a back key; a light shielding frame (110) equipping a internal hollow formed surrounding and covering every side of a light emitting member (L) protruding on a side of a substrate (10) in an area (10a, 10b) equipped with a menu key and a back key and having a greater thickness than the protruding size of the light emitting member (L); a white sheet (120) equipped through a internal hollow of the light shielding frame (110); a wave guide sheet (140) laminated on the white sheet (120); and a tape member (150) attaching to a back of the light shielding frame (110) is provided.

## Description

### BACKGROUND

### 1. Technical Field

An embodiment according to the present invention relates to a wave guide structure for key module of mobile device and the forming method thereof, and more particularly a wave guide structure for key module of mobile device and the forming method thereof using a light shielding frame surrounding and covering a light emitting member and improving productivity by having a simpler structure than prior arts and also securing light shielding function on areas other than wave guide.

### 2. Description of the Related Art

Recently, with the rapid development of mobile communication technology, public popularity for various mobile devices such as smart phones, tablet PCs is growing.

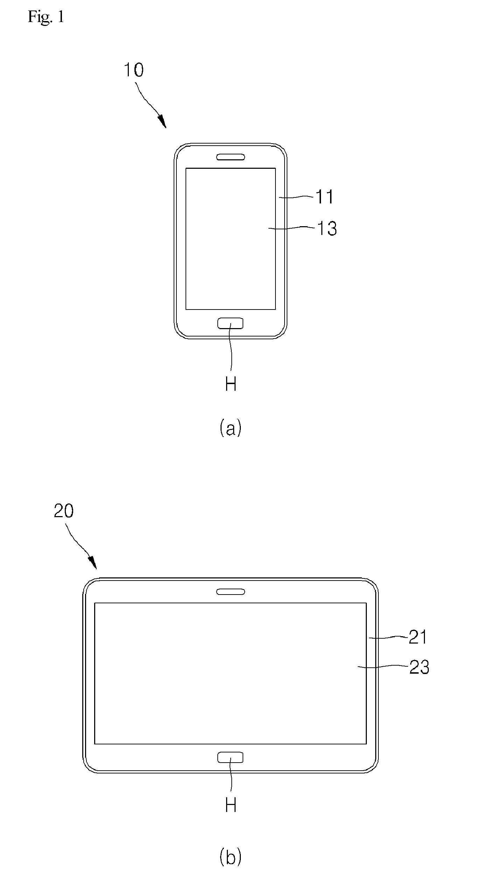

FIG. 1 is a view illustrating simplified examples of mobile devices.

A smart phone is illustrated in FIG. 1 (a), and a tablet PC is illustrated in FIG. 1 (b). The smart phone (10) and the tablet PC (20) generally comprises a main body (11, 12), a display device (12, 23) equipped on the front of the main body, and a home key (H) equipped on one side, typically center on the lower side, of the display device.

Also, the home key (H) is equipped to realize a configured action in a mobile device, such as returning to an initial display or performing another function when a home key (H) is pressed when a mobile device is used.

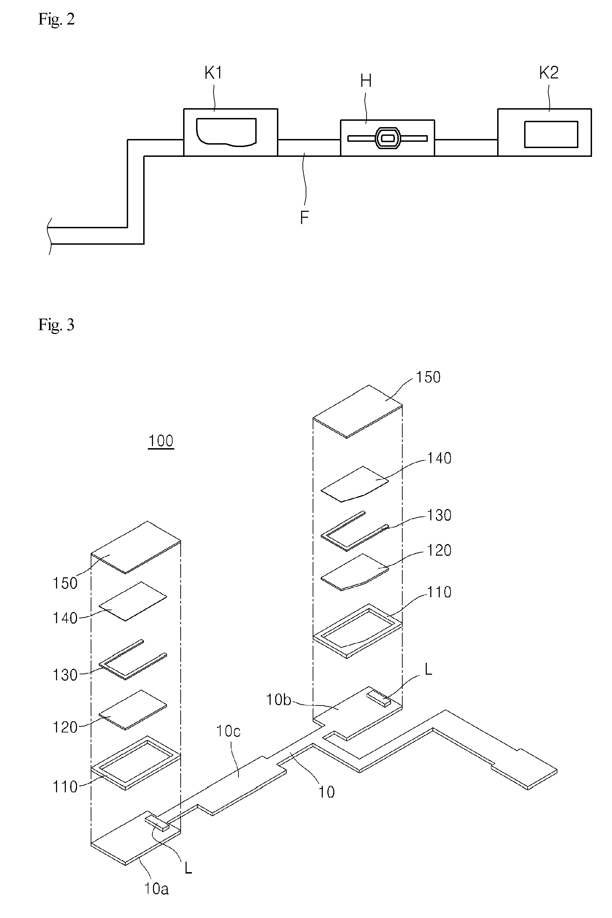

FIG. 2 is a simplified view illustrating a key module equipped with a home key, a back key, a menu key, etc. of a mobile device.

The illustrated key module is equipped on the front bottom part of majority of mobile devices, and mostly a home key (H) is equipped in the middle, and back key (K1) and menu key (K2) are equipped on both sides.

And, back key (K1) and menu key (K2) are offered by illuminating from an illumination method such as LED, etc. equipped in a key module. As such, a structure guiding a light emitted from a light emitting method equipped separately in a key module to the back key (K1) and the menu key (K2) is called a wave guide structure for key modules.

But, traditional wave guide structure for key modules consists of a structure folding and covering a separate tape type shielding member after attaching a wave guide on a surface of a substrate and the forming shape is complex, and acts a cause for decrease in productivity due to difficulty of work.

Korean Patent Publication No. 2009-0055462 (published on June 02, 2009) is a prior art relating to the present invention, and technology relating to a key switch structure is mentioned in the prior publication.

### BRIEF SUMMARY

The present invention is provided to provide a wave guide structure for key module of mobile device and the forming method thereof improving productivity using a light shield surrounding and covering a light emitting member and also securing a shielding function.

It should be understood that the present invention is not limited to solving the mentioned problems, other problems not mentioned will become apparent to those skilled in the arts from the following descriptions.

In accordance with an embodiment of the present invention, a wave guide structure for key module of mobile device comprising a light shielding frame formed surrounding and covering every side of a light emitting member protruding on a side of a substrate in an area equipped with a menu key and a back key and having a greater thickness than the protruding size of the light emitting member is provided.

The light shielding frame further comprises an internal hollow surrounding and covering every side of the light emitting member.

The light shielding frame is a poron material.

And in accordance with an embodiment of the present invention, a wave guide structure for key module of mobile device comprising, a substrate equipped with a menu key and a back key; a light shielding frame equipping a internal hollow formed surrounding and covering every side of a light emitting member protruding on a side of a substrate in an area equipped with a menu key and a back key and having a greater thickness than the protruding size of the light emitting member; a white sheet equipped through a internal hollow of the light shielding frame; a wave guide sheet laminated on the white sheet; and a tape member attaching to a back of the light shielding frame is provided. The shielding frame is a poron material.

A double-sided tape is equipped between the white sheet and the wave guide sheet, and the double-sided tape is a form of ' 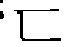 ', and the double-sided tape is arranged so that the open part of the ' 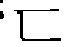 ' form points to the light emitting member.

The tape member is provided in a size and form according to the light shielding frame, and back of the light shielding frame is sealed through attaching the tape member.

Also, in accordance with an embodiment of the present invention, a forming method of a wave guide structure for key module of mobile device comprising, preparing a substrate equipping a menu key and a back key; preparing a light shielding frame formed surrounding and covering every side of a light emitting member protruding on a side of a substrate and having a greater thickness than the protruding size of the light emitting member and equipping the light shielding frame on the area of the menu key and back key; equipping a white sheet through an internal hollow of the light shielding frame; laminating a wave guide sheet on the white sheet; and attaching a tape member on the back of the light shielding frame, and sealing the back of the light shielding frame is provided.

A double-sided tape is equipped on the white sheet before equipping the wave guide sheet, and the double-sided tape is a form of ' 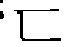 ', and the double-sided tape is arranged so that the open part of the ' 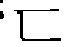 ' form points to the light emitting member.

According to an embodiment of the present invention, light shielding function may be improved while having a simpler structure compared to prior arts by using a light shielding frame surrounding and covering a light emitting member.

Also, according to an embodiment of the present invention, as a light shielding frame is formed surrounding and covering every side of a light emitting member and thicker than the light emitting member, productivity may be improved because a separate procedure to cover a substrate using a tape type light shielding method such in prior arts is not required.

### BRIEF DESCRIPTION OF THE DRAWINGS

FIG 1. is a simplified view illustrating a smart phone and a tablet PC as an example of a mobile device.
FIG 2. is a simplified view illustrating a home key substrate of a mobile device.
FIG 3. is a simplified perspective view illustrating a wave guide structure of a key module of a mobile device according to an embodiment of the present invention.
FIG 4. is a simplified exploded perspective view illustrating a wave guide structure of a key module of a mobile device according to an embodiment of the present invention.
FIG 5. is a simplified exploded perspective view illustrating a placement relationship between a light shielding frame and a light emitting member according to an embodiment of the present invention.
FIG 6. is an enlarged view showing area A of FIG 5.
FIG 7. is a flow chart briefly illustrating a forming method of a wave guide structure for key module of mobile device according to an embodiment of the present invention.

### DETAILED DESCRIPTION

The terms and vocabulary used in the specification and claims of the present invention should not be interpreted as limited to its general or its literal meaning, and should be interpreted as definition and concepts corresponding to the technical idea of the present invention based on the principle that an inventor may appropriately define the notion of terms to describe the invention in the best way possible,

Also, exemplary embodiments and configuration illustrated in the drawings described herein are only one of the preferred embodiments, and it should be understood that various modifications, variations and alterations can be made without departing from the scope of the invention.

Hereinafter, a wave guide structure for key module of mobile device and the forming method thereof in accordance with an embodiment of the present invention will be described with reference to the accompanying drawings.

An aspect of a wave guide structure for key module of mobile device and the forming method thereof in accordance with an exemplary embodiments of the present invention is to secure a light shielding function while simplifying working process by using a light shielding frame formed surrounding and covering every side of a light emitting member and thicker than the light emitting member.

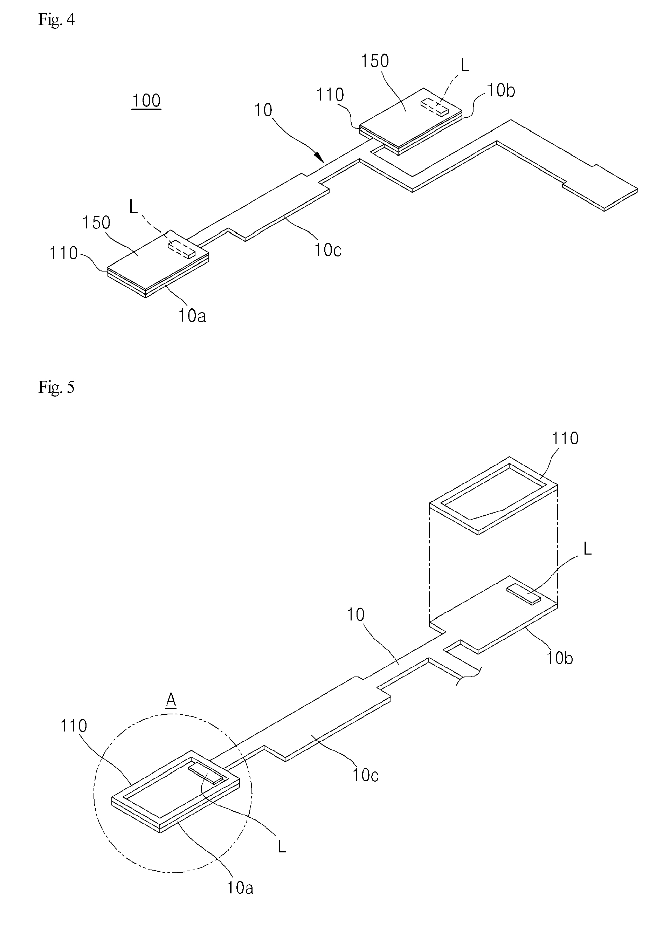

In the drawings, FIG. 3 is a simplified perspective view illustrating a wave guide structure of a key module of a mobile device according to an embodiment of the present invention, and FIG. 4 is a simplified exploded perspective view illustrating a wave guide structure of a key module of a mobile device according to an embodiment of the present invention.

A wave guide structure for key module of mobile device (100) (referred to as wave guide structure for key module below) comprises a light shielding frame (110) formed surrounding and covering every side of a light emitting member (L) protruding on a side of a substrate (10) in areas (10a, 10b) equipped with a menu key and a back key and having a greater thickness than the protruding size of the light emitting member.

The substrate (10) may be a key module substrate equipped in the front lower part of a mobile device.

An area (10c) equipped mostly with a home key is prepared in the center part of the substrate (10), areas (10a, 10b) equipped with a menu key and an back key may be prepared on each side.

And the illustrated substrate (10) illustrates a back image of a key module substrate.

And the wave guide structure for key module (100) describes a structure providing a guide for a light emitting from a light emitting member (L) such as an LED equipped on the substrate, etc. to the menu key, back key, etc.

Especially, the light shielding frame (110) may be provided in a form with an internal hollow surrounding and covering every side of the light emitting member (L), and desirably provided as a poron material.

Meanwhile, referring to FIG. 3, wave guide structure for key module (100) in accordance with an embodiment of the present invention comprises a substrate (10) providing areas (10a, 10b) equipped with menu key and back key, a light shielding frame (110) equipped in each of the areas (10a, 10b), a white sheet (120), a double-sided tape (130), a wave guide sheet (140), and a tape member (150).

The light shielding frame (110) may be formed surrounding and covering every side of a light emitting member protruding on a side of areas (10a, 10b) equipped with the menu key and the back key. For this, a rectangular shaped internal hollow may be prepared inside the light shielding frame (110).

And the light shielding frame (110) may have a greater thickness than the size of the protrusion of the light emitting member (L). And the light shielding frame (110) may be sealed through attaching a tape member (150), which will be described below, to the back of the light shielding frame (110).

And the white sheet (120) and the wave guide sheet (140) may be manufactured in advance.

It is desirable for the white sheet (120) and the wave guide sheet (140) to have a size and shape to be housed through an internal hollow of the light shielding frame (110).

Meanwhile, a double-sided tape (130) may be additionally equipped between the white sheet (120) and the wave guide sheet (140).

The double-sided tape may have a ' 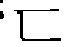 ' shape as illustrated in FIG. 3. And it is desirable to arrange the double-sided tape (130) so that the open part of the ' 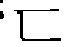 'shape (131) points to the light emitting member (L).

The tape member (150) may be provided in a size and shape corresponding to the light shielding frame (110).

Referring to FIG. 4, the tape member (150) is attached to the back of the light shielding frame (110), and outside exposure of the white sheet and the wave guide sheet equipped inside the light shielding frame (110) is blocked and sealed.

Next, referring to FIG. 5, a placement relationship between a light shielding frame (110) in accordance with an embodiment of the present invention and a light emitting member (L) equipped on a substrate in areas (10a, 10b) equipped with a menu key and a back key is described.

As illustrated, a light emitting member (L), which is equipped on a substrate in areas (10a, 10b) equipped with a menu key and a back key, is equipped, and the light shielding frame (110) in a form of surrounding and covering every side of the light emitting member (L) may be equipped.

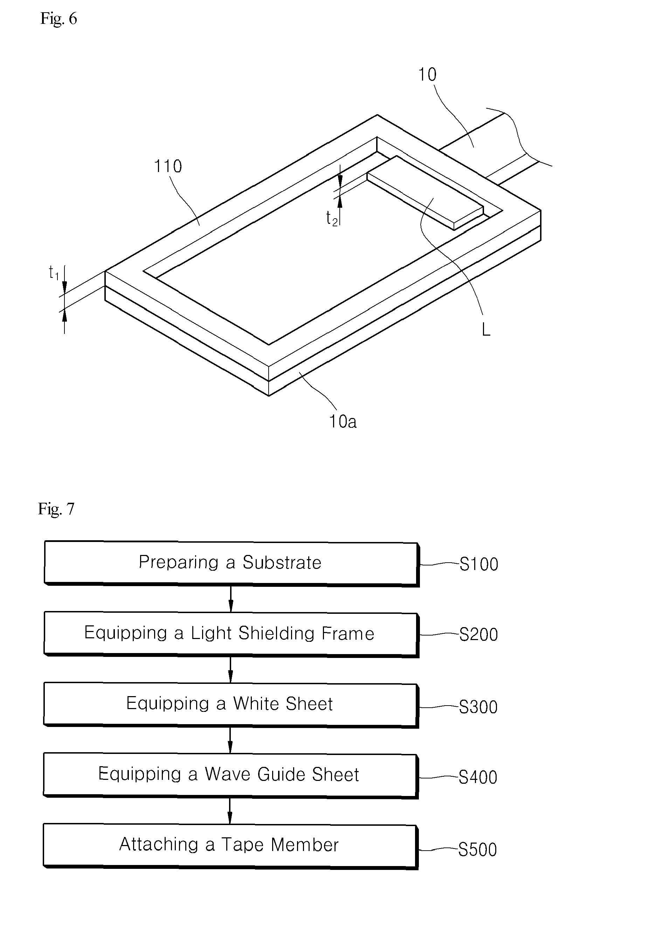

FIG. 6 is an enlarged view showing area A of FIG. 5. Referring to FIG. 6, it can be identified that a light emitting member is protruding with a size of t2 on a side of a substrate with the figure symbol 10a.

This is for the light shielding frame (110) to have a relatively greater thickness than the protrusion size of the light emitting member (L), so that the light emitting member (L) is completely housed inside the light shielding frame (110) and is completely surrounded and covered.

Furthermore, when a tape member (150) is attached to the back of the light shielding frame (110), not only the light emitting member (L) but also the white sheet (120) and the wave guide sheet (130) may all be sealed and housed through an internal hollow of the light shielding frame (110).

FIG 7. is a flow chart briefly illustrating a forming method of a wave guide structure for key module of mobile device according to an embodiment of the present invention.

Referring to FIG. 7, forming method of a wave guide structure for key module of mobile device comprises preparing a substrate (S100), equipping light shielding frame (S200), equipping a white sheet (S300), equipping a wave guide sheet (S400) and attaching a tape member (S500).

First, preparing a substrate (S100) is carried out. This step is a step where a substrate of a mobile device equipped with a menu key, a back key, and a home key is prepared, and all of the commonly known substrates may be used for the substrate, and as a detailed example, FPCB, etc. may be used.

Next, equipping light shielding frame (S200) is carried out. A shielding frame surrounding and covering every side of the light emitting member protruding on a side of the substrate and having a greater thickness than the size of the light emitting member protrusion is prepared. Also, the light shielding frame is equipped in an area where the menu key and the back key are equipped.

Next, equipping white sheet step (S300) and equipping a wave guide sheet step (S400) is carried out. In these steps, white sheet and wave guide sheet, which are prepared with an internal hollow of the light shielding frame, which is prepared in the step before (S200), is prepared.

At this time, a double-sided tape between the white sheet and the wave guide sheet may be additionally equipped. The double-sided tape may be provided in a ' 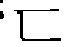 ' shape.

Next, attaching a tape member (S500) is carried out. The tape member in this stage is attached to the back of the light shielding frame and may seal the internal hollow of the light shielding frame from the outside.

As describe above, according to an embodiment of the present invention, light shielding function may be improved with a simpler structure compared to prior arts by using a light shielding frame surrounding and covering a light emitting member.

Also, according to an embodiment of the present invention, as a light shielding frame formed surrounding and covering every side of a light emitting member thicker than the light emitting member, productivity may be improved because a separate procedure to cover a substrate using a tape type light shielding method such in prior arts is not required

A wave guide structure for key module of mobile device and the forming method thereof in accordance with an preferred embodiment of the present invention was described above.

Although some exemplary embodiments have been described herein, it should be understood that the present invention is not limited to the embodiments and it should be understood by those skilled in the art that these embodiments are given by way of illustration only, and the scope of the present invention will be defined only by the claims. And it should be understood that all possible modifications, variations and alterations made from the claims described hereinafter and conceptual equivalent therefrom is within the scope of the present invention.

### [Description of Symbols]

10 : Substrate
100 : Key Module Wave Guide Structure
110 : Light Shielding Frame
120: White Sheet
130 : Double-Sided Tape
140 : Wave Guide Sheet
150: Tape Member

## Claims

1. A wave guide structure for key module of mobile device comprising a light shielding frame formed surrounding and covering every side of a light emitting member protruding on a side of a substrate in an area equipped with a menu key and a back key and having a greater thickness than the protruding size of the light emitting member.

2. The structure according to claim 1, wherein the light shielding frame further comprises an internal hollow surrounding and covering every side of the light emitting member.

3. The structure according to claim 1, wherein the light shielding frame is a poron material.

4. A wave guide structure for key module of mobile device comprising,
a substrate equipped with a menu key and a back key;
a light shielding frame equipping a internal hollow formed surrounding and covering every side of a light emitting member protruding on a side of a substrate in an area equipped with a menu key and a back key and having a greater thickness than the protruding size of the light emitting member;
a white sheet equipped through a internal hollow of the light shielding frame;
a wave guide sheet laminated on the white sheet; and
a tape member attaching to a back of the light shielding frame.

5. The structure according to claim 4, wherein the shielding frame is a poron material.

6. The structure according to claim 4, wherein a double-sided tape is equipped between the white sheet and the wave guide sheet, and the double-sided tape has a form of ' 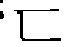 ', and the double-sided tape is arranged so that the open part of the ' 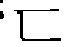 ' form points to the light emitting member.

7. The structure according to claim 4, wherein the tape member is provided in a size and form according to the light shielding frame, and back of the light shielding frame is sealed through attaching the tape member.

8. A forming method of a wave guide structure for key module of mobile device comprising, preparing a substrate equipping a menu key and a back key;
preparing a light shielding frame formed surrounding and covering every side of a light emitting member protruding on a side of a substrate and having a greater thickness than the protruding size of the light emitting member and equipping the light shielding frame on the area of the menu key and back key;
equipping a white sheet through an internal hollow of the light shielding frame;
laminating a wave guide sheet on the white sheet; and
attaching a tape member on the back of the light shielding frame, and sealing the back of the light shielding frame.

9. The method according to claim 8, wherein a forming method of wave guide structure for key module of mobile device further comprises,
equipping a double-sided tape on the white sheet before equipping the wave guide sheet, the double-sided tape has a form of ' 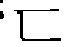 ', and the double-sided tape is arranged so that the open part of the ' 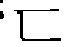 ' form points to the light emitting member.
